# EUROPÄISCHE PATENTSCHRIFT

(11) **EP 3 827 454 B1**
(45) Veröffentlichungstag und Bekanntmachung des Hinweises auf die Patenterteilung: **30.08.2023**
(21) Anmeldenummer: 19769078.7
(22) Anmeldetag: 04.09.2019
(51) Int. Cl.: H01H 11/00, G01R 31/12, H01H 33/12, H01H 33/00, H01H 33/16

(54) **HOCHSPANNUNGSEINRICHTUNG UND VERFAHREN ZUR EINSTELLUNG VON EIGENSCHAFTEN DER HOCHSPANNUNGSEINRICHTUNG**
HIGH VOLTAGE DEVICE AND METHOD FOR THE ADJUSTMENT OF THE CHARACTERISTICS OF THE HIGH VOLTAGE DEVICE
INSTALLATION À HAUTE TENSION ET PROCÉDÉ DE RÉGLAGE DES CARACTÉRISTIQUES D'UNE INSTALLATION À HAUTE TENSION

(30) Priorität: 13.09.2018 DE 102018215610
(43) Veröffentlichungstag der Anmeldung: 02.06.2021
(73) Patentinhaber: Siemens Aktiengesellschaft, 80333 München (DE)
(72) Erfinder: CERNAT, Radu-Marian, 10585 Berlin (DE); CHYLA, Thomas, 14089 Berlin (DE); DOHNKE, Oliver, 14513 Teltow (DE); GIERE, Stefan, 13595 Berlin (DE); GROTH, Rudolf, 16548 Glienicke (DE); HARTIG, Prosper, 12555 Berlin (DE); LECHELER, Stefan, 12277 Berlin (DE); TEICHMANN, Jörg, 14624 Dallgow-Döberitz (DE); WIESINGER, Claudia, 14089 Berlin (DE)
(74) Vertreter: Siemens Patent Attorneys
(86) Internationale Anmeldenummer: PCT/EP2019/073502
(87) Internationale Veröffentlichungsnummer: WO 2020/053037

(56) Entgegenhaltungen:
- US-A- 4 894 785
- US-A- 5 107 447
- US-A1- 2009 256 427
- US-B1- 6 362 445

## Beschreibung

Die Erfindung betrifft eine Hochspannungseinrichtung und ein Verfahren zur Einstellung von Eigenschaften einer Hochspannungseinrichtung, mit einer Vorrichtung für Hochspannungen und mit wenigstens einem Sensor zur Messung von Umweltdaten.

In der Hochspannungstechnik werden z. B. Leistungsschalter, Transformatoren, Instrument Transformer, Trenner, Erder und/oder Ableiter als Hochspannungseinrichtungen eingesetzt. Die Hochspannungseinrichtungen, wie z. B. aus der US 5 107 447 A, der US 6 362 445 B1, der US 2009/256427 A1, und US 4 894 785 A bekannt ist, werden zum Transport und/oder zur Verteilung von Spannungen und Strömen im Bereich von bis zu 1200 kV und einigen hundert Ampere verwendet. Aus der EP 1 109 185 A2 ist z. B. ein Hochspannungs-Leistungsschalter als Hochspannungseinrichtung zum Schalten bekannt. Ein Sensor erfasst die Stellung von Kontaktstücken eines elektrischen Kontakts im Hochspannungs-Leistungsschalter. Abhängig von den Sensordaten kann der Hochspannungs-Leistungsschalter bzw. die Bewegung der Kontaktstücke gesteuert werden.

Der Hochspannungs-Leistungsschalter ist entsprechend Nennanforderungen ausgelegt, insbesondere maximal zu schaltenden Strömen und/oder Spannungen in einem vorgegebenen Bereich von Umweltparametern. Um in einem großen Bereich von Umweltparametern wie z. B. Temperatur, Luftdruck, Windlast, Feuchtigkeit und/oder Sonneneinstrahlung zuverlässig die maximal zu schaltenden Ströme und/oder Spannungen ohne Beschädigung und/oder Zerstörung schalten zu können, sind die Hochspannungs-Leistungsschalter mit einer Dimensionierung konstruiert, welche hohe Reserven umfasst. So sind z. B. Isolatoren, in welchen elektrische Schaltkontakte angeordnet sind, für große Luftdruckbereiche und Windlasten ausgelegt. Abstände von elektrischen Kontakten sind für hohe Luftfeuchtigkeit ausgelegt. Die Schaltgeschwindigkeit, d. h. der Antrieb, Getriebeteile und/oder die Schaltstange sind ausgelegt für hohe Windgeschwindigkeit, unterschiedliche Windrichtungen und hohe Windlasten, in einem breiten Temperaturbereich.

Hohe Reserven in der Dimensionierung der Hochspannungseinrichtungen erzeugen unter anderem hohe Produktionskosten, eine großen Materialaufwand und einen großen Platzbedarf.

Aufgabe der vorliegenden Erfindung ist es, eine Hochspannungseinrichtung und ein Verfahren zur Einstellung von Eigenschaften einer Hochspannungseinrichtung anzugeben, welche die zuvor beschriebenen Probleme lösen. Insbesondere ist es Aufgabe, eine einfache, zuverlässige, kostengünstige Hochspannungseinrichtung und ein Verfahren zur Einstellung von Eigenschaften der Hochspannungseinrichtung anzugeben, welche Kosten, Material und Platzbedarf einsparen.

Die angegebene Aufgabe wird erfindungsgemäß durch eine Hochspannungseinrichtung mit den Merkmalen gemäß Patentanspruch 1 und/oder durch ein Verfahren zur Einstellung von Eigenschaften einer Hochspannungseinrichtung, insbesondere einer zuvor beschriebenen Hochspannungseinrichtung, gemäß Patentanspruch 9 gelöst. Vorteilhafte Ausgestaltungen der erfindungsgemäßen Hochspannungseinrichtung und/oder des Verfahrens zur Einstellung von Eigenschaften einer Hochspannungseinrichtung, insbesondere einer zuvor beschriebenen Hochspannungseinrichtung, sind in den Unteransprüchen angegeben. Dabei sind Gegenstände der Hauptansprüche untereinander und mit Merkmalen von Unteransprüchen sowie Merkmale der Unteransprüche untereinander kombinierbar.

Eine erfindungsgemäße Hochspannungseinrichtung umfasst eine Vorrichtung für Hochspannungen und wenigstens einen Sensor zur Messung von Umweltdaten. Abhängig von den gemessenen Sensorparametern sind Einstellungen der Vorrichtung anpassbar.

Dadurch können Kosten, Material und Platz eingespart werden. Die Vorrichtung muss nicht wie im Stand der Technik mit großen Reserven in der Dimensionierung ausgelegt werden, denn abhängig von Umweltparametern kann die Hochspannungseinrichtung eingestellt, d. h. verändert werden.

So kann z. B. bei einem Hochspannungs-Leistungsschalter mit Isolatorgehäuse der Isolator mit einer geringeren Wandstärke gefertigt werden. Bei Änderung, insbesondere Erhöhung des Luftdrucks durch Wettereinflüsse kann im Isolatorgehäuse der Druck erhöht werden, z. B. bei einem Clean Air Leistungsschalter mit Vakuumröhre kann der Clean Air Innendruck im Leistungsschalter erhöht werden, und somit ein Gegendruck zum äußeren Luftdruck geschaffen werden. Dadurch kann eine geringere Wandstärke des Isolators verwendet werden, bei gleicher Zuverlässigkeit und mechanischer Stabilität des Leistungsschalters.

Bei Erhöhung der Luftfeuchtigkeit kann z. B. die maximal zulässige, d. h. schalbare Spannung angepasst werden und/oder der Abstand von Kontaktstücken erhöht werden. Bei einer Windlast oberhalb kritischer Werte kann die Hochspannungseinrichtung abgeschaltet werden und außer Betrieb genommen werden. Abhängig vom Aufstellungsort, insbesondere ab einer bestimmten Aufstellungshöhe z. B. in Bergen, kann die maximal schaltbare Leistung angepasst werden oder der Schalter außer Betrieb bleiben, d. h. ein Einschalten des Schalters aktiv, z. B. über eine Steuerung und/oder Regelung verhindert werden. Dies sind nur ausgewählte Beispiele für Einstellungen, welche, abhängig von mit dem Sensor gemessenen Umweltparametern, an der Vorrichtung der Hochspannungseinrichtung eingestellt werden können.

Die Vorrichtung kann einen Transformator, einen Instrument Transformer, einen Trenner, einen Erder und/oder einen Ableiter umfassen. Die Vorteile sind wie zuvor beschrieben. Z. B. kann bei beweglichen Freiluftteilen, insbesondere Trenner- und/oder Erderarmen, abhängig von Niederschlag und/oder Temperatur eine Eislast berechnet werden, und eine Antriebskraft abhängig vom berechneten Wert eingestellt werden und/oder bei Überschreiten eines kritischen Wertes kann die Hochspannungseinrichtung aktiv außer Betrieb genommen werden, um z. B. irreversible Beschädigungen zu vermeiden.

Der Sensor kann ein Luftdruck-, ein Temperatur-, ein Luftfeuchtigkeits-, ein Regen-, ein Windgeschwindigkeits-, ein Windrichtungs-, ein Partikel- und/oder ein Strahlungs-Sensor, und/oder ein Lichtstrahlungs-Sensor sein. Die beispielhaft genannten Sensor-Typen können Umweltparameter ermitteln, insbesondere kostengünstig über Standard-Sensoren, und abhängig von einzelnen Werten und/oder von Wertekombinationen bzw. Berechnungen aus den Werten/Wertekombinationen können Einstellungen vorgenommen werden. Ein Beispiel für eine Wertekombination ist die Temperatur und die Luftfeuchtigkeit, aus welchen ein Taupunkt berechnet werden kann, bei welchem eine Feuchtigkeitsbildung an der Hochspannungseinrichtung stattfindet. Feuchtigkeit kann zu einer verringerten elektrischen Isolation führen, womit abhängig vom Taupunkt und/oder Regen eine Isolatorstrecke zwischen elektrischen Anschlüssen verlängert werden kann und/oder eine schaltbare Höchstspannung herabgesetzt bzw. erhöht werden kann.

Ein Nennstrom wird erfindungsgemäß abhängig von Windgeschwindigkeit, Windrichtung und/oder Temperatur einstellbar. Hohe Temperaturen und geringe Windgeschwindigkeiten können zu lokaler Überhitzung stromdurchflossener Teile bei hohem Nennstrom führen. Dadurch können z. B. irreversible Zerstörungen und/oder Beschädigungen erfolgen. Eine hohe Windgeschwindigkeit, insbesondere aus bestimmten Richtungen, kann zu Zerstörungen und/oder Beschädigungen der Hochspannungseinrichtung führen. Bei Überschreitung kritischer Werte kann z. B. die Hochspannungseinrichtung aktiv außer Betrieb genommen werden.

Die Vorrichtung umfasst einen Hochspannungs-Leistungsschalter, dessen Nennstrom abhängig von Windgeschwindigkeit, Windrichtung und/oder Temperatur einstellbar ist, durch Zu- und/oder Abschaltung von Widerständen. Dadurch ist z. B. die Zuverlässigkeit der Hochspannungseinrichtung erhöht.

Eine Spannung wird abhängig von Luftdruck, Windrichtung und/oder Windgeschwindigkeit einstellbar. Eine Änderung des Luftdrucks kann analog einer Änderung der Luftfeuchtigkeit Isoliereigenschaften über einen Luftspalt verändern, insbesondere eine nötige minimale Isolierstrecke bei vorgegebener Spannung verringern oder vergrößern. Windgeschwindigkeit und/oder Windrichtung können zu unkontrollierten Bewegungen von Teilen der Hochspannungseinrichtung führen, z. B. zu Schwingungen von Erder- und/oder Trennerarmen, welche eine Änderung der schaltbaren maximalen Spannung erfordern. Eine Anpassung der Spannung, insbesondere der maximal schaltbaren Spannung abhängig von Umweltparametern wie z. B. Luftdruck, Windrichtung und/oder Windgeschwindigkeit, kann zu einer erhöhten Zuverlässigkeit der Hochspannungseinrichtung führen. Material und Kosten können eingespart werden, da die Anlage mit geringeren Sicherheitstoleranzen ausgelegt werden kann, und eine zuverlässige Funktion über die Einstellung der maximal zulässigen Schaltspannung erfolgt.

Die Vorrichtung umfasst einen Hochspannungs-Leistungsschalter, dessen schaltbare Spannung abhängig von Luftdruck, Windrichtung und/oder Windgeschwindigkeit einstellbar ist, durch Änderung von Abständen von Kontaktstücken eines elektrischen Kontakts im ausgeschalteten Zustand, mit den zuvor beschriebenen Vorteilen.

Ein Kurzschlussstrom wird abhängig von Windgeschwindigkeit, Windrichtung und/oder von Windlast einstellbar.

Die Vorrichtung umfasst einen Hochspannungs-Leistungsschalter, dessen Kurzschlussstrom abhängig von Windgeschwindigkeit, Windrichtung und/oder von Windlast einstellbar ist, durch Einstellung der Schaltgeschwindigkeit z. B. von Lichtbogen- und/oder Nennstromkontaktstücken. Die Vorteile sind analog den zuvor in Bezug auf die Einstellung von Spannung beschriebenen Vorteilen.

Eine Vorrichtung zum Abschalten und/oder zur Außerbetriebnahme der Hochspannungseinrichtung kann umfasst sein, welche abhängig von Ortsdaten, insbesondere eines GPS-Empfängers, und/oder abhängig von Luftdruckdaten, insbesondere zur Bestimmung einer Aufstellungshöhe, ausgebildet ist, die Hochspannungseinrichtung elektrisch vom Hochspannungsnetz zu trennen und/oder außer Betrieb zu nehmen. Die Vorrichtung zum Abschalten und/oder zur Außerbetriebnahme kann auch eine Inbetriebnahme verhindern, abhängig der ermittelten Umweltmessdaten und/oder der Ortskoordinaten, insbesondere der Höhenwerte.

Eine Vorrichtung, insbesondere eine Datenverarbeitungseinheit und/oder eine Datensendeeinheit in Verbindung mit der Cloud können umfasst sein, welche zur Bestimmung von Wartungsintervallen ausgebildet sind, insbesondere zum Vergleich von Entwicklungsdaten mit Umweltdaten des wenigstens einen Sensors. Kritische Zustände der Hochspannungseinrichtung können an Hand von Entwicklungsdaten und/oder gespeicherten Daten aus der Vergangenheit und deren Vergleich mit Umweltdaten, welche vom wenigstens einen Sensor gemessenen wurden, ermittelt werden und es kann z. B. eine Wartung der Hochspannungseinrichtung ausgelöst bzw. beauftragt werden.

Ein erfindungsgemäßes Verfahren zur Einstellung von Eigenschaften einer zuvor beschriebenen Hochspannungseinrichtung, umfasst, dass wenigstens ein Sensor Umweltdaten in der Umgebung der Hochspannungseinrichtung misst, und abhängig von den gemessenen Sensorparametern Eigenschaften wenigstens einer Vorrichtung der Hochspannungseinrichtung eingestellt werden.

Als Hochspannungseinrichtung kann ein Hochspannungs-Leistungsschalter, ein Transformator, ein Instrument Transformer, ein Trenner, ein Erder und/oder ein Ableiter bezüglich Nennstrom, Spannung und/oder Kurzschlussstrom eingestellt werden, abhängig von mit dem wenigstens einen Sensor gemessenen Werten von Luftdruck, Temperatur, Luftfeuchtigkeit, Regenmenge, Windgeschwindigkeit, Windrichtung, Partikeln und/oder Strahlung, insbesondere Lichtstrahlung.

Wartungsintervalle können bestimmt werden, insbesondere durch Vergleich von mit dem wenigstens einen Sensor gemessenen Werten und Entwicklungsdaten. Die Hochspannungseinrichtung kann geschaltet, insbesondere abgeschaltet werden, abhängig von gemessenen Umweltdaten, insbesondere nach Vergleich von gemessenen Werten für Umweltdaten und Entwicklungsdaten.

Die Hochspannungseinrichtung kann abhängig von gemessenen Werten des wenigstens einen Sensors, mit GPS-Daten und/oder Luftdruck-Daten, dauerhaft abgeschaltet werden oder eine Einschaltung kann verhindert werden, bei Messung von Sensor-Daten, welche von vordefinierten Nennanforderungen abweichen und/oder bezüglich Aufstellungsort und/oder Aufstellungshöhe abweichen.

Die Vorteile des erfindungsgemäßen Verfahrens zur Einstellung von Eigenschaften einer Hochspannungseinrichtung, insbesondere einer zuvor beschriebenen Hochspannungseinrichtung, gemäß Anspruch 9 sind analog den zuvor beschriebenen Vorteilen der erfindungsgemäßen Hochspannungseinrichtung gemäß Anspruch 1 und umgekehrt.

Im Folgenden wird ein Ausführungsbeispiel der Erfindung schematisch in der einzigen Figur dargestellt und nachfolgend näher beschrieben.

Dabei zeigt die
- Figur: schematisch in Schnittansicht eine erfindungsgemäße Hochspannungseinrichtung 1 von einer Seite betrachtet, mit einer Vorrichtung 2 für Hochspannungen und mit einem Sensor 3 zur Messung von Umweltdaten.

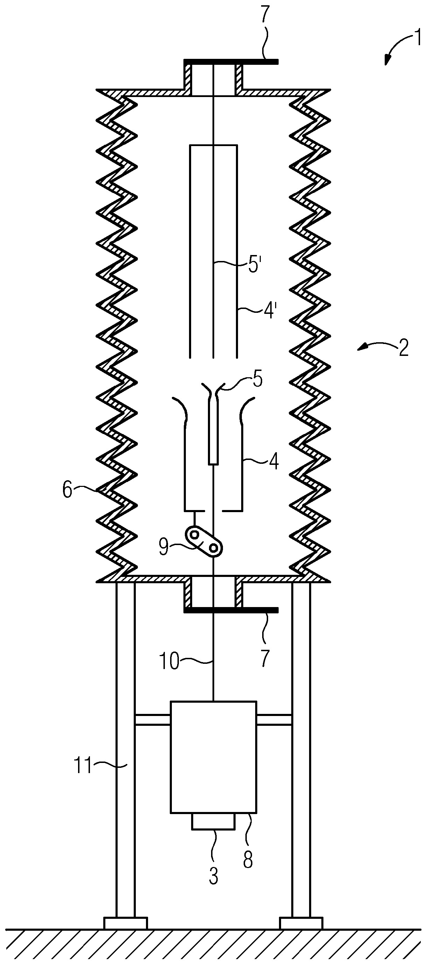

In Figur 1 ist schematisch in Schnittansicht eine erfindungsgemäße Hochspannungseinrichtung 1 von einer Seite betrachtet dargestellt. Die Hochspannungseinrichtung 1 umfasst eine Vorrichtung 2 für Hochspannungen, welche beispielhaft als Hochspannungs-Leistungsschalter mit einem Nennstrom- und einem Lichtbogenkontakt ausgeführt ist. Der Nennstromkontakt umfasst ein insbesondere tulpenförmiges und ein komplementäres Kontaktstück 4, 4', wobei wenigstens ein Kontaktstück 4 und/oder 4` beweglich ausgeführt ist. Der Lichtbogenkontakt umfasst ebenfalls ein insbesondere tulpenförmiges und ein komplementäres Kontaktstück 5, 5', wobei wenigstens ein Kontaktstück 5 und/oder 5` beweglich ausgeführt ist. Die Vorrichtung 2 mit den Kontaktstücken 4, 4', 5, 5` ist zum Schalten hoher Spannungen, insbesondere im Bereich von bis zu 1200 kV, und/oder hohen Strömen, insbesondere im Bereich von bis zu einigen hundert Ampere, ausgelegt.

Die Kontaktstücke 4, 4', 5, 5` zum Schalten sind in einem Isolator 6, insbesondere in einem außen gerippten, hohlzylinderförmigen Isolatorgehäuse 6 angeordnet. An den Enden des hohlzylinderförmigen Isolatorgehäuses 6 sind an der Grund- und Deckfläche jeweils Hochspannungsanschlüsse 7 zum Anschluss an elektrische Verbraucher, Stromerzeuger und/oder an ein Stromnetz angeordnet. Die Anschlüsse 7 sind durch die Grund- und Deckfläche jeweils gasdicht in das Innere des Isolators 6 geführt und mit den jeweiligen Kontaktstücken 4, 4', 5, 5` elektrisch leitend verbunden. Die beweglichen Kontaktstücke 4, 5, und/oder 4`, 5` sind z. B. über ein Getriebe mit einem Antrieb, insbesondere einem Federspeicherantrieb, z. B. über eine Antriebsstange 10 verbunden. Beim Schalten wird Bewegungsenergie vom Antrieb, über Getriebeelemente 9 und die Antriebsstange 10 auf die beweglichen Kontaktstücke 4, 5 übertragen.

Das Isolatorgehäuse 6 mit den Nennstrom- und Lichtbogen-Kontaktstücken 4, 4', 5, 5` sowie mit den Hochspannungsanschlüssen 7, ist auf einem Traggestell 11 z. B. aus Stahlträgern angeordnet. Der Antrieb im Antriebsgehäuse 8 ist ebenfalls am Traggestell 11 befestigt. Getriebeelemente 9 sind z. B. im Antriebsgehäuse 8 und/oder im Isolatorgehäuse 6 angeordnet. Die Schaltstange 10 bzw. Antriebsstange ist gasdicht in das Isolatorgehäuse 6 geführt. Das Isolatorgehäuse 6 ist z. B. mit Clean Air und/oder SF₆ als Schaltgas befüllt. Alternativ zum zuvor beschriebenen Leistungsschalter mit Nennstrom- und Lichtbogen-Kontaktstücken 4, 4', 5, 5` kann eine oder mehr Vakuumröhren verwendet werden.

Erfindungsgemäß umfasst die Hochspannungseinrichtung 1 wenigstens einen Sensor 3 zur Messung von Umweltdaten. Dabei kann der Sensor einzelne Parameter oder eine Kombination von Parametern wie z. B. Temperatur, Luftdruck, Feuchtigkeit, insbesondere Luftfeuchtigkeit, Windrichtung, Windgeschwindigkeit, GPS-Ortsdaten und/oder Strahlung messen.

Abhängig von den gemessenen Sensorparametern werden Einstellungen der Vorrichtung 2 wie z. B. Schaltgeschwindigkeit, insbesondere über Getriebeteile und/oder dem Antrieb, Isolatorlänge bzw. Kriechstromlänge zwischen Hochspannungsanschlüssen 7, Spaltabstände zwischen Kontaktstücken 4, 4', 5, 5', Gasdruck im Isolatorgehäuse 6, insbesondere des Schalt- und/oder Isoliergases wie z. B. SF₆ oder Clean Air, die Geschwindigkeit von Lichtbogen-Ausblasströmungen, die maximale Schaltspannung, und/oder der Kurzschlussstrom angepasst. Bei Über- und/oder Unterschreiten von kritischen Schwellwerten der Sensorparameter, insbesondere vorgespeicherter Werte verglichen mit aktuell gemessenen Werten des bzw. der Sensoren zur Messung von Umweltdaten 3, kann eine Abschaltung oder das Verhindern einer Inbetriebnahme ausgelöst werden. Dies kann insbesondere abhängig vom Luftdruck-, von Temperatur-, von Luftfeuchtigkeit, von Regen, von Windgeschwindigkeiten, von Windrichtung, von Strahlung, insbesondere von Partikel- und/oder Lichtstrahlung, erfolgen.

Der Nennstrom der Hochspannungseinrichtung 1 kann insbesondere abhängig von Windgeschwindigkeit, Windrichtung und/oder Temperatur eingestellt werden. Bei hohen Windgeschwindigkeiten und/oder Temperaturen, oder ungünstigen Windrichtungen, kann der Nennstrom der Vorrichtung 2 reduziert werden, um eine Beschädigung der Hochspannungseinrichtung 1 zu vermeiden und eine sichere, zuverlässige Funktion wie z. B. ein Schalten zu gewährleisten. So kann bei Sturm oder Windrichtungen, welche eine hohe Windlast erzeugen, der Nennstrom reduziert werden, um eine sichere Funktion des Stromnetzes zu gewährleisten.

Die schaltbare Spannung kann insbesondere abhängig von Luftdruck, Windrichtung und/oder Windgeschwindigkeit eingestellt werden. Dies kann z. B. durch Änderung von Abständen von Kontaktstücken 4, 4', 5, 5` eines elektrischen Kontakts im ausgeschalteten Zustand eines Hochspannungs-Leistungsschalters erfolgen. Bei z. B. hohem Luftdruck, hoher Luftfeuchtigkeit und/oder starker Windlast oder Schwingungen durch Windeinwirkungen, kann der Abstand der Kontaktstücke 4, 4', 5, 5` erhöht werden, um einen sicheren ausgeschalteten Zustand zu gewährleisten. Dadurch kann eine hohe schaltbare Spannung erhalten werden bzw. die schaltbare Spannung erhöht werden.

Der Kurzschlussstrom kann insbesondere abhängig von Windgeschwindigkeit, Windrichtung und/oder von Windlast einstellbar sein, z. B. durch Einstellung der Schaltgeschwindigkeit, insbesondere von Lichtbogen- 5, 5` und/oder Nennstromkontaktstücken 4, 4`. Bei hoher Schaltgeschwindigkeit kann trotz hoher Windlast ein hoher Kurzschlussstrom zuverlässig geschaltet werden, und/oder einer hohen Wahrscheinlichkeit eines Kurzschlusses im Netzt kann durch Erhöhung der Schaltgeschwindigkeit Rechnung getragen werden.

Abhängig von Ortsdaten, insbesondere eines GPS-Empfängers, und/oder abhängig von Luftdruckdaten, insbesondere zur Bestimmung einer Aufstellungshöhe des Hochspannungs-Leistungsschalters, kann die Hochspannungseinrichtung 1 elektrisch vom Hochspannungsnetz getrennt werden und/oder außer Betrieb bleiben, d. h. eine Inbetriebnahme verhindert werden. Dadurch kann eine Fehlfunktion durch Aufstellung außerhalb zugelassener Orte und/oder Werten vermieden werden.

Eine Datenverarbeitungseinheit und/oder eine Datensendeeinheit in Verbindung mit der Cloud kann umfasst sein, welche der Einfachheit halber in der Figur nicht dargestellt ist. Die Datenverarbeitungseinheit und/oder eine Datensendeeinheit in Verbindung mit der Cloud kann zur Bestimmung von Wartungsintervallen ausgebildet sein, insbesondere zum Vergleich von Entwicklungsdaten mit Umweltdaten des wenigstens einen Sensors 3. Bei kritischen, vordefinierten Messdaten des Sensors 3 und/oder Datenverläufen, kann eine Wartung ausgelöst werden und/oder ein Wartungsintervall verkürzt werden.

Durch die Messung der Umweltdaten bzw. Umweltparameter kann ein zuverlässiger, sicherer, langzeitstabiler Betrieb der Hochspannungseinrichtung 1 gewährleistet werden, und bei kritischen Werten kann die Hochspannungseinrichtung 1 außer Betrieb genommen werden. Dadurch kann die Hochspannungseinrichtung 1 einfacher und kostengünstiger ausgelegt werden, da weniger Puffer in der Auslegung notwendig ist um einen sicheren, zuverlässigen Betrieb auch bei ungünstigen Bedingungen zu gewährleisten.

Die zuvor beschriebenen Ausführungsbeispiele können untereinander kombiniert werden und/oder können mit dem Stand der Technik kombiniert werden. So können z. B. statt Hochspannungs-Leistungsschalter Transformatoren, Instrument Transformer, Trenner, Erder und/oder Ableiter verwendet werden. Eine Abschaltung der Hochspannungseinrichtung 1, eine Reduzierung z. B. der Schaltspannung und/oder des Kurzschlussstroms kann bei mechanischer Belastung, z. B. durch ungünstige Windrichtung, z. B. senkrecht zu einem Trennerarm oder Erderarm, erfolgen und/oder bei hohen oder niedrigen Temperaturen, bei welchen z. B. ein Schaltgas an Isolierwirkung verliert, und/oder hoher Luftfeuchtigkeit, bei welcher eine Isolierwirkung z. B. über den Isolator reduziert ist, und/oder bei Regen, und/oder bei hoher Sonneneinstrahlung, bei welcher eine schnellere Alterung von Materialien erfolgt und/oder Materialien sich aufheizen können.

Kritische Werte, gemessen mit Hilfe des oder der Sensoren 3, können durch Vergleich mit vordefinierten Werten, insbesondere mit bei der Konstruktion und/oder Zulassung bestimmten und vordefinierten Werten, ermittelt werden und vor Ort gespeichert und verarbeitet, oder z. B. über Datenübermittlungseinrichtungen in Zentralen und/oder der Cloud verarbeitet und von/zur Hochspannungseinrichtung 1 übermittelt werden. Abhängig von den gemessenen Sensorparametern und den daraus ermittelten kritischen Werten können die Einstellungen der Vorrichtung 2 angepasst werden.

Ein Sensor 3, oder mehr als ein Sensor 3, können z. B. an einem Gehäuse, insbesondere dem Antriebsgehäuse 8 befestigt sein, und/oder an anderen Teilen der Vorrichtung 2 und/oder der Hochspannungseinrichtung 1, wie z. B. am Traggestell 11, und/oder dem Isolatorgehäuse 6, und/oder den Hochspannungsanschlüssen 7, und/oder der Schaltstange 10, und/oder außen liegenden Getriebeelementen 9 befestigt sein. Der wenigstens eine Sensor 3 kann auch entfernt von der Vorrichtung 2 für Hochspannungen angeordnet sein, insbesondere auf einem Schaltfeld z. B. im Bereich einer Steuerzentrale. Kabelgebundene- und/oder Funkübertragungseinrichtungen, wie z. B. elektrische und/oder optische Leitungen, W-Lan, Bluetooth, und/oder Mobilfunk, können vorgesehen sein, die Messwerte des wenigstens einen Sensors 3 an die Vorrichtung 1 für Hochspannungen direkt oder z. B. über wenigstens eine Datenverarbeitungseinheit und/oder das Internet, z. B. in Verbindung mit der Cloud, zu übermitteln, um abhängig von den gemessenen Sensorparametern die Einstellungen der Vorrichtung 2 anzupassen.

### Bezugszeichenliste

- 1: Hochspannungseinrichtung
- 2: Vorrichtung für Hochspannungen
- 3: Sensor zur Messung von Umweltdaten
- 4: Nennstrom-Kontaktstücke eines elektrischen Kontakts eines Leistungsschalters (Tulpen- und Stab-Kontaktstück 4, 4`)
- 5: Lichtbogen-Kontaktstücke eines elektrischen Kontakts eines Leistungsschalters (Tulpen- und Stab-Kontaktstück 5, 5')
- 6: Isolatorgehäuse
- 7: Hochspannungsanschlüsse
- 8: Antriebsgehäuse
- 9: Getriebeelement
- 10: Antriebsstange
- 11: Traggestell

## Patentansprüche

1. Hochspannungseinrichtung (1), mit einer Vorrichtung (2) für Hochspannungen und mit wenigstens einem Sensor (3) zur Messung von Umweltdaten, wobei abhängig von den gemessenen Sensorparametern Einstellungen der Vorrichtung (2) anpassbar sind,
wobei die Vorrichtung (2) einen Hochspannungs-Leistungsschalter umfasst, **dadurch gekennzeichnet, dass**
dessen Nennstrom abhängig von Windgeschwindigkeit, Windrichtung und/oder Temperatur einstellbar ist, und/oder dessen schaltbare Spannung abhängig von Luftdruck, Windrichtung und/oder Windgeschwindigkeit einstellbar ist, und/oder dessen Kurzschlussstrom abhängig von Windgeschwindigkeit, Windrichtung und/oder von Windlast einstellbar ist.

2. Hochspannungseinrichtung (1) nach Anspruch 1, **dadurch gekennzeichnet, dass**
die Vorrichtung (2)
einen Transformator, einen Instrument Transformer, einen Trenner, einen Erder und/oder einen Ableiter umfasst.

3. Hochspannungseinrichtung (1) nach einem der vorhergehenden Ansprüche,
**dadurch gekennzeichnet, dass**
der Sensor (3) ein Luftdruck-, ein Temperatur-, ein Luftfeuchtigkeits-, ein Regen-, ein Windgeschwindigkeits-, ein Windrichtungs-, ein Partikel- und/oder ein Strahlungs-Sensor, und/oder ein Lichtstrahlungs-Sensor ist.

4. Hochspannungseinrichtung (1) nach einem der vorhergehenden Ansprüche,
**dadurch gekennzeichnet, dass**
die Vorrichtung (2) einen Hochspannungs-Leistungsschalter umfasst, dessen Nennstrom abhängig von Windgeschwindigkeit, Windrichtung und/oder Temperatur einstellbar ist, durch Zu- und/oder Abschaltung von Widerständen.

5. Hochspannungseinrichtung (1) nach einem der vorhergehenden Ansprüche,
**dadurch gekennzeichnet, dass**
die Vorrichtung (2) einen Hochspannungs-Leistungsschalter umfasst, dessen schaltbare Spannung abhängig von Luftdruck, Windrichtung und/oder Windgeschwindigkeit einstellbar ist, durch Änderung von Abständen von Kontaktstücken (4, 4', 5, 5') eines elektrischen Kontakts im ausgeschalteten Zustand.

6. Hochspannungseinrichtung (1) nach einem der vorhergehenden Ansprüche,
**dadurch gekennzeichnet, dass**
die Vorrichtung (2) einen Hochspannungs-Leistungsschalter umfasst, dessen Kurzschlussstrom abhängig von Windgeschwindigkeit, Windrichtung und/oder von Windlast einstellbar ist, durch Einstellung der Schaltgeschwindigkeit, insbesondere von Lichtbogen- (5, 5') und/oder Nennstromkontaktstücken (4, 4').

7. Hochspannungseinrichtung (1) nach einem der vorhergehenden Ansprüche,
**dadurch gekennzeichnet, dass**
eine Vorrichtung zum Abschalten und/oder zur Außerbetriebnahme der Hochspannungseinrichtung (1) umfasst ist, welche abhängig von Ortsdaten, insbesondere eines GPS-Empfängers, und/oder abhängig von Luftdruckdaten, insbesondere zur Bestimmung einer Aufstellungshöhe, ausgebildet ist, die Hochspannungseinrichtung (1) elektrisch vom Hochspannungsnetz zu trennen und/oder außer Betrieb zu nehmen.

8. Hochspannungseinrichtung (1) nach einem der vorhergehenden Ansprüche,
**dadurch gekennzeichnet, dass**
eine Vorrichtung, insbesondere eine Datenverarbeitungseinheit und/oder eine Datensendeeinheit in Verbindung mit der Cloud umfasst ist, welche zur Bestimmung von Wartungsintervallen ausgebildet ist, insbesondere zum Vergleich von Entwicklungsdaten mit Umweltdaten des wenigstens einen Sensors (3).

9. Verfahren zur Einstellung von Eigenschaften einer Hochspannungseinrichtung (1) nach einem der vorhergehenden Ansprüche,
**dadurch gekennzeichnet, dass**
wenigstens ein Sensor (3) Umweltdaten in der Umgebung der Hochspannungseinrichtung (1) misst, und abhängig von den gemessenen Sensorparametern Eigenschaften wenigstens einer Vorrichtung (2) der Hochspannungseinrichtung (1) eingestellt werden.

10. Verfahren nach Anspruch 9,
**dadurch gekennzeichnet, dass**
als Hochspannungseinrichtung (1) ein Hochspannungs-Leistungsschalter, ein Transformator, ein Instrument Transformer, ein Trenner, ein Erder und/oder ein Ableiter bezüglich Nennstrom, Spannung und/oder Kurzschlussstrom eingestellt werden, abhängig von mit dem wenigstens einen Sensor (3) gemessenen Werten von Luftdruck, Temperatur, Luftfeuchtigkeit, Regenmenge, Windgeschwindigkeit, Windrichtung, Partikeln und/oder Strahlung, insbesondere Lichtstrahlung.

11. Verfahren nach einem der Ansprüche 9 oder 10,
**dadurch gekennzeichnet,**
**dass** Wartungsintervalle bestimmt werden, insbesondere durch Vergleich von mit dem wenigstens einen Sensor (3) gemessenen Werten und Entwicklungsdaten, und/oder dass die Hochspannungseinrichtung (1) geschaltet, insbesondere abgeschaltet wird, abhängig von gemessenen Umweltdaten, insbesondere nach Vergleich von gemessenen Werten für Umweltdaten und Entwicklungsdaten.

12. Verfahren nach einem der Ansprüche 9 bis 11,
**dadurch gekennzeichnet, dass**
die Hochspannungseinrichtung (1) abhängig von gemessenen Werten des wenigstens einen Sensors (3) mit GPS-Daten und/oder Luftdruck-Daten, dauerhaft abgeschaltet wird, bei Messung von Sensor-Daten, welche von vordefinierten Nennanforderungen abweichen und/oder bezüglich Aufstellungsort und/oder Aufstellungshöhe abweichen.

## Claims

1. High-voltage device (1), having an apparatus (2) for high voltages and having at least one sensor (3) for measuring environmental data, wherein the measured sensor parameters can be used to adjust settings of the apparatus (2), wherein the apparatus (2) comprises a high-voltage circuit breaker,
**characterized in that**
the nominal current of said high-voltage circuit breaker can be set on the basis of wind speed, wind direction and/or temperature, and/or the switchable voltage of said high-voltage circuit breaker can be set on the basis of air pressure, wind direction and/or wind speed, and/or the short-circuit current of said high-voltage circuit breaker can be set on the basis of wind speed, wind direction and/or wind load.

2. High-voltage device (1) according to Claim 1,
**characterized in that**
the apparatus (2) comprises a transformer, an instrument transformer, an isolator, an earth electrode and/or an arrester.

3. High-voltage device (1) according to either of the preceding claims,
**characterized in that**
the sensor (3) is an air pressure sensor, a temperature sensor, a humidity sensor, a rain sensor, a wind speed sensor, a wind direction sensor, a particle sensor and/or a radiation sensor, and/or a light radiation sensor.

4. High-voltage device (1) according to one of the preceding claims,
**characterized in that**
the apparatus (2) comprises a high-voltage circuit breaker the nominal current of which can be set on the basis of wind speed, wind direction and/or temperature by connecting and/or disconnecting resistors.

5. High-voltage device (1) according to one of the preceding claims,
**characterized in that**
the apparatus (2) comprises a high-voltage circuit breaker the switchable voltage of which can be set on the basis of air pressure, wind direction and/or wind speed by changing distances between contact pieces (4, 4', 5, 5') of an electrical contact in the switched-off state.

6. High-voltage device (1) according to one of the preceding claims,
**characterized in that**
the apparatus (2) comprises a high-voltage circuit breaker the short-circuit current of which can be set on the basis of wind speed, wind direction and/or wind load by setting the switching speed, in particular of arcing contact pieces (5, 5') and/or nominal current contact pieces (4, 4').

7. High-voltage device (1) according to one of the preceding claims,
**characterized in that**
it comprises an apparatus for disconnecting and/or shutting down the high-voltage device (1), which apparatus is designed to use location data, in particular from a GPS receiver, and/or air pressure data, in particular for determining an installation altitude, to electrically isolate the high-voltage device (1) from the high-voltage grid and/or to shut it down.

8. High-voltage device (1) according to one of the preceding claims,
**characterized in that**
it comprises an apparatus, in particular a data processing unit and/or a data transmission unit connected to the cloud, which apparatus is designed for determining maintenance intervals, in particular for comparing development data with environmental data from the at least one sensor (3).

9. Method for setting properties of a high-voltage device (1) according to one of the preceding claims,
**characterized in that**
at least one sensor (3) measures environmental data in the surroundings of the high-voltage device (1), and the measured sensor parameters are used to set properties of at least one apparatus (2) of the high-voltage device (1).

10. Method according to Claim 9,
**characterized in that**
a high-voltage circuit breaker, a transformer, an instrument transformer, an isolator, an earth electrode and/or an arrester as the high-voltage device (1) have their nominal current, voltage and/or short-circuit current set on the basis of values of air pressure, temperature, humidity, amount of rain, wind speed, wind direction, particles and/or radiation, in particular light radiation, measured by the at least one sensor (3) .

11. Method according to either of Claims 9 and 10,
**characterized**
**in that** maintenance intervals are determined, in particular by comparing values measured by the at least one sensor (3) and development data, and/or in that the high-voltage device (1) is switched, in particular disconnected, on the basis of measured environmental data, in particular after comparing measured values for environmental data and development data.

12. Method according to one of Claims 9 to 11,
**characterized in that**
the high-voltage device (1) is permanently disconnected on the basis of measured values from the at least one sensor (3) containing GPS data and/or air pressure data when sensor data which deviate from predefined nominal requirements and/or deviate in terms of installation location and/or installation altitude are measured.

## Revendications

1. Équipement à haute tension (1), muni d'un dispositif (2) destiné aux hautes tensions et d'au moins un capteur (3) permettant de mesurer des données environnementales, dans lequel des ajustements du dispositif (2) peuvent être adaptés en fonction des paramètres de capteur mesurés,
dans lequel le dispositif (2) comprend un disjoncteur haute tension, **caractérisé en ce que**
le courant nominal dudit disjoncteur haute tension peut être ajusté en fonction de la vitesse du vent, de la direction du vent et/ou de la température, et/ou la tension commutable dudit disjoncteur haute tension peut être ajustée en fonction de la pression atmosphérique, de la direction du vent et/ou de la vitesse du vent, et/ou le courant de court-circuit dudit disjoncteur haute tension peut être ajusté en fonction de la vitesse du vent, de la direction du vent et/ou de la charge de vent.

2. Équipement à haute tension (1) selon la revendication 1,
**caractérisé en ce que**
le dispositif (2) comprend un transformateur, un transformateur de mesure, un séparateur, une mise à la terre et/ou un parafoudre.

3. Équipement à haute tension (1) selon l'une quelconque des revendications précédentes,
**caractérisé en ce que**
le capteur (3) est un capteur de pression atmosphérique, de température, d'humidité atmosphérique, de pluie, de vitesse du vent, de direction du vent, de particules et/ou de rayonnement, et/ou un capteur de rayonnement lumineux.

4. Équipement à haute tension (1) selon l'une quelconque des revendications précédentes,
**caractérisé en ce que**
le dispositif (2) comprend un disjoncteur haute tension dont le courant nominal peut être ajusté en fonction de la vitesse du vent, de la direction du vent et/ou de la température, par activation et/ou désactivation de résistances.

5. Équipement à haute tension (1) selon l'une quelconque des revendications précédentes,
**caractérisé en ce que**
le dispositif (2) comprend un disjoncteur haute tension dont la tension commutable peut être ajustée en fonction de la pression atmosphérique, de la direction du vent et/ou de la vitesse du vent, par modification des distances entre les pièces de contact (4, 4', 5, 5') d'un contact électrique à l'état éteint.

6. Équipement à haute tension (1) selon l'une quelconque des revendications précédentes,
**caractérisé en ce que**
le dispositif (2) comprend un disjoncteur haute tension dont le courant de court-circuit peut être ajusté en fonction de la vitesse du vent, de la direction du vent et/ou de la charge de vent, par ajustement de la vitesse de commutation, en particulier des pièces de contact d'arc (5, 5') et/ou des pièces de contact de courant nominal (4, 4').

7. Équipement à haute tension (1) selon l'une quelconque des revendications précédentes,
**caractérisé en ce que**
ledit équipement à haute tension comprend un dispositif permettant de désactiver et/ou mettre hors service l'équipement à haute tension (1) et conçu pour déconnecter électriquement l'équipement à haute tension (1) par rapport au réseau à haute tension et/ou le mettre hors service, en fonction de données géographiques, en particulier issues d'un récepteur GPS, et/ou en fonction de données de pression atmosphérique, en particulier afin de déterminer une hauteur d'installation.

8. Équipement à haute tension (1) selon l'une quelconque des revendications précédentes,
**caractérisé en ce que**
ledit équipement à haute tension comprend un dispositif, en particulier une unité de traitement de données et/ou une unité d'émission de données en liaison avec le nuage informatique, conçu pour déterminer des intervalles de maintenance, en particulier pour comparer des données de développement avec des données environnementales du au moins un capteur (3).

9. Procédé d'ajustement des caractéristiques d'un équipement à haute tension (1) selon l'une quelconque des revendications précédentes,
**caractérisé en ce que**
au moins un capteur (3) mesure des données environnementales dans l'environnement de l'équipement à haute tension (1) et des propriétés d'au moins un dispositif (2) de l'équipement à haute tension (1) sont ajustées en fonction des paramètres de capteur mesurés.

10. Procédé selon la revendication 9,
**caractérisé en ce que**
afin de faire office d'équipement à haute tension (1), un disjoncteur haute tension, un transformateur, un transformateur de mesure, un séparateur, une mise à la terre et/ou un dissipateur voient leur courant nominal, leur tension et/ou leur courant de court-circuit ajustés en fonction de valeurs, mesurées grâce à au moins un capteur (3), de pression atmosphérique, de température, d'humidité atmosphérique, de quantité de pluie, de vitesse du vent, de direction du vent, de particules et/ou de rayonnement, en particulier de rayonnement lumineux.

11. Procédé selon la revendication 9 ou 10,
**caractérisé en ce que**
des intervalles de maintenance sont déterminés, en particulier en comparant des valeurs et des données de développement mesurées grâce au au moins un capteur (3), et/ou **en ce que** l'équipement à haute tension (1) est activé, en particulier désactivé, en fonction de données environnementales mesurées, en particulier après comparaison des valeurs mesurées pour les données environnementales et pour les données de développement.

12. Procédé selon l'une quelconque des revendications 9 à 11, **caractérisé en ce que**
l'équipement à haute tension (1) est désactivé durablement en fonction des valeurs mesurées du au moins un capteur (3) et de données GPS et/ou de données de pression atmosphérique, lorsque sont mesurées des données de capteur qui s'écartent d'exigences nominales prédéfinies et/ou qui divergent du lieu d'installation et/ou de la hauteur d'installation.
